# EUROPEAN PATENT SPECIFICATION

(11) **EP 4 254 481 B1**
(45) Date of publication and mention of the grant of the patent: **03.09.2025**
(21) Application number: 21931062.0
(22) Date of filing: 02.07.2021
(51) Int. Cl.: H10D 30/60, H10D 64/27, H10D 64/68, H01L 21/28, H10B 12/00, H10D 64/01

(54) **SEMICONDUCTOR STRUCTURE MANUFACTURING METHOD AND SEMICONDUCTOR STRUCTURE**
VERFAHREN ZUR HERSTELLUNG EINER HALBLEITERSTRUKTUR UND HALBLEITERSTRUKTUR
PROCÉDÉ DE FABRICATION DE STRUCTURE SEMI-CONDUCTRICE ET STRUCTURE SEMI-CONDUCTRICE

(30) Priority: 15.03.2021 CN 202110277455
(43) Date of publication of application: 04.10.2023
(73) Proprietor: Changxin Memory Technologies, Inc., Hefei, Anhui 230601 (CN)
(72) Inventor: GUO, Shuai, Hefei, Anhui 230601 (CN)
(74) Representative: Gulde & Partner
(86) International application number: PCT/CN2021/104346
(87) International publication number: WO 2022/193479

(56) References cited:
- CN-A- 1 795 539
- CN-A- 108 389 837
- CN-A- 108 389 837
- CN-A- 110 197 870
- US-A1- 2008 042 195
- US-A1- 2009 253 243
- US-A1- 2010 207 203
- US-B2- 9 508 548
- US-B2- 9 680 004
- US-B2- 9 984 882

## Description

### CROSS-REFERENCE TO RELATED APPLICATION

This application claims priority to Chinese Patent Application No. 202110277455.8, filed to the Chinese Intellectual Property Office on March 15, 2021 and entitled "METHOD FOR MANUFACTURING SEMICONDUCTOR STRUCTURE AND SEMICONDUCTOR STRUCTURE".

### TECHNICAL FIELD

The present application relates to the technical field of semiconductors, and in particular, to a method for manufacturing a semiconductor structure and a semiconductor structure.

### BACKGROUND

A dynamic random access memory (DRAM) is a semiconductor memory in which data can be written and read at high speed and randomly, and is widely used in data storage devices or apparatuses.

The dynamic random access memory consists of a plurality of repeat memory units, each of the plurality of memory units generally include a capacitor structure and a transistor, and a gate electrode of the transistor is connected to a word line, a drain electrode of the transistor is connected to a bit line, and a source electrode of the transistor is connected to the capacitor structure; and a voltage signal on the word line can control turn-on or turn-off of the transistor, thereby reading data information stored in the capacitor structure by means of the bit line, or writing data information into the capacitor structure by means of the bit line for storage.

With the increasing integration of the dynamic random access memory, a width of the word line becomes smaller, and further, a structure size of the transistor becomes smaller, easily generating gate induced drain leakage (GIDL) and reducing performance of a semiconductor structure. Related technology is known from US2008/042195A, CN108389 837A, US9984882B2 and US9508548B2.

### SUMMARY

The invention is defined by the independent claims.

In the method for manufacturing the semiconductor structure and the semiconductor structure provided by embodiments of the present application, by means of a deposition process, the thickness of the first oxide portion covering the side walls of each of the trench structures is greater than the thickness of the second oxide portion covering the bottom wall of each of the trench structures; and by means of nitriding treatment, the concentration of nitrogen ions in the first oxide portion is less than the concentration of nitrogen ions in the second oxide portion, so that a dielectric constant of the first oxide portion is less than a dielectric constant of the second oxide portion. Such an arrangement can ensure that the semiconductor structure generates small gate induced drain leakage at a junction between the gate structure and a source electrode and a junction between the gate structure and a drain electrode, and can also improve turn-on current of the semiconductor structure, thereby improving sensitivity of the semiconductor structure.

In addition to the technical problems solved by the embodiments of the present application, the technical features constituting the technical solutions, and the beneficial effects brought about by the technical features of the technical solutions, other technical problems that can be solved by the method for manufacturing a semiconductor structure and the semiconductor structure provided by the embodiments of the present application, other technical features included in the technical solutions, and beneficial effects brought about by the technical features will be further described in detail in the detailed description of the embodiments.

### BRIEF DESCRIPTION OF THE DRAWINGS

Fig. 1 is a process flowchart of a method for manufacturing a semiconductor structure provided by the embodiments of the present application;
Fig. 2 is a schematic diagram of the structure of a substrate in the method for manufacturing the semiconductor structure provided by the embodiments of the present application;
Fig. 3 is a schematic diagram of the structure after an oxide layer is formed in the method for manufacturing the semiconductor structure provided by the embodiments of the present application;
Fig. 4 is a process diagram of nitriding treatment on the oxide layer in the method for manufacturing the semiconductor structure provided by the embodiments of the present application;
Fig. 5 is a schematic diagram of the structure of forming an initial barrier layer in the method for manufacturing the semiconductor structure provided by the embodiments of the present application;
Fig. 6 is a process diagram of removing residual chloride ions in the method for manufacturing the semiconductor structure provided by the embodiments of the present application;
Fig. 7 is a schematic diagram of the structure of forming an initial conductive layer in the method for manufacturing the semiconductor structure provided by the embodiments of the present application;
Fig. 8 is a schematic diagram of the structure of flattening the initial conductive layer in the method for manufacturing the semiconductor structure provided by the embodiments of the present application;
Fig. 9 is a schematic diagram of the structure of forming a gate structure in the method for manufacturing the semiconductor structure provided by the embodiments of the present application;
Fig. 10 is a schematic diagram of the structure of forming a gate protection layer in the method for manufacturing the semiconductor structure provided by the embodiments of the present application.

### Reference signs

10: substrate; 11: trench structure;
12: source region; 13: drain region;
20: oxide layer; 21: first oxide portion;
22: second oxide portion; 30: gate structure;
31: initial conductive layer; 40: initial barrier layer;
41: barrier layer; 50: gate protection layer.

### DETAILED DESCRIPTION OF THE EMBODIMENTS

With continuous reduction of size of a semiconductor structure, a line width and a trench size of the semiconductor structure become smaller, and a thickness of oxide layer formed on side walls and a bottom wall of the trench is reduced. Due to the reduction of the thickness of the oxide layer, for the semiconductor structure, signal resolution is weakened, storage speed is slow, and gate induced drain leakage is easily generated.

With regard to the described technical problems, the embodiments of the present application provide a method for manufacturing a semiconductor structure, and a semiconductor structure. By means of a deposition process, a thickness of a first oxide portion covering side walls of a trench structure is greater than a thickness of a second oxide portion covering a bottom wall of the trench structure; and by means of nitriding treatment, a concentration of nitrogen ions in the first oxide portion is less than a concentration of nitrogen ions in the second oxide portion, so that a dielectric constant of the first oxide portion is less than a dielectric constant of the second oxide portion. Such an arrangement can ensure that the semiconductor structure generates small gate induced drain leakage at a junction between a gate structure and a source electrode and a junction between the gate structure and a drain electrode, thereby improving sensitivity of the semiconductor structure.

In order to make described objectives, features, and advantages of the embodiments of the present application more obvious and understandable, the technical solutions in the embodiments of the present application will be described clearly and completely with reference to the drawings in the embodiments of the present application. Obviously, the embodiments to be described are only a part rather than all of the embodiments of the present application.

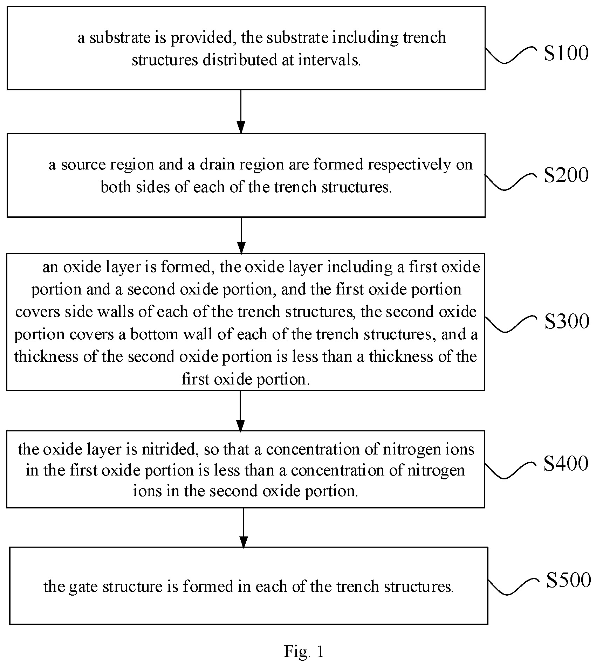

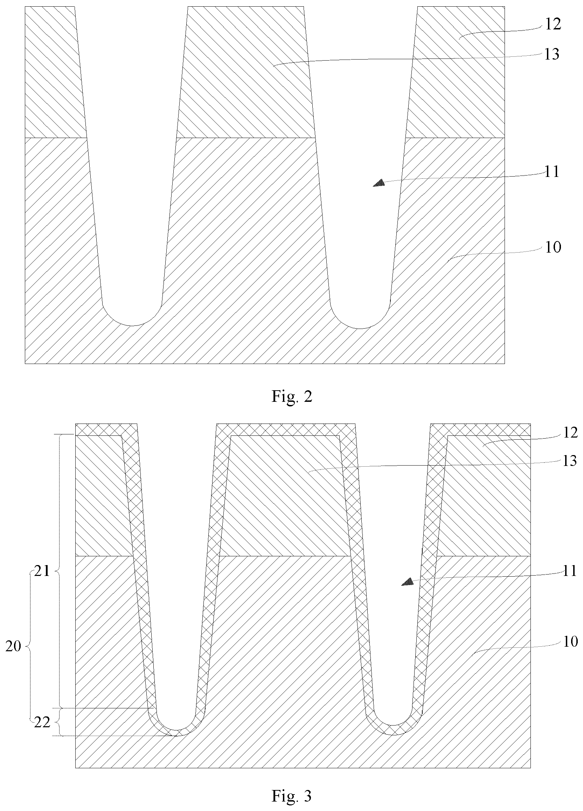

Fig. 1 is a flowchart of the method for manufacturing the semiconductor structure provided by the embodiments of the present application. Figs. 2-10 are schematic diagrams of various stages of the method for manufacturing the semiconductor structure. The method for manufacturing the semiconductor structure will be described in detail below with reference to Figs. 2-10.

The semiconductor structure is not limited in the embodiments, and the semiconductor structure is introduced below by taking a dynamic random access memory (DRAM) as an example, but the embodiments are not limited thereto, and the semiconductor structure in the embodiments are also other structures.

As shown in Fig. 1, the embodiments of the present application provide the method for manufacturing the semiconductor structure, including the following steps:
Step S100: a substrate is provided, the substrate including trench structures distributed at intervals.

As shown in Fig. 2, the semiconductor structure includes the substrate 10. The substrate 10 serves as a supporting component of a memory and is used for supporting other components provided thereon. The substrate 10 is made of a semiconductor material, and the semiconductor material is one or more of silicon, germanium, silicon-germanium compound and silicon-carbide compound.

The trench structures 11 are provided at intervals in the substrate 10, the trench structures 11 are used for exposing a part of the active region, and a gate structure is provided in each of the trench structures 11, so as to achieve the electrical connection between the gate structure and the active region.

Specifically, a photoresist layer is formed on the substrate 10, and the photoresist layer is patterned by means of exposure, development or etching, so as to form openings provided at intervals in the photoresist layer.

After the openings are formed, the substrate 10 exposed in the openings is removed by an etching liquid or an etching gas, so as to form the trench structures 11 provided at intervals in the substrate 10.

Step S200: a source region and a drain region are formed respectively on both sides of each of the trench structures.

Exemplarily, a mask is provided, the mask is used to shield the trench structures 11, so as to expose regions located at both sides of each of the trench structures 11, and ions are doped into the regions located at both sides of each of the trench structures 11 by an ion implantation process, for example, doped ions are arsenic ions or boron ions, so as to form a source region 12 and a drain region 13 of the semiconductor structure.

Step S300: an oxide layer is formed, the oxide layer including a first oxide portion and a second oxide portion, and the first oxide portion covers side walls of each of the trench structures, the second oxide portion covers a bottom wall of each of the trench structures, and a thickness of the second oxide portion is less than a thickness of the first oxide portion.

Exemplarily, as shown in Fig. 3, a silicon oxide layer is formed on the side walls and the bottom wall of each of the trench structures 11 and a top surface of the substrate 10 by an atomic layer deposition process, and the silicon oxide layer covering the side walls of the substrate 10 forms the first oxide portion 21, and the silicon oxide layer covering the bottom wall of the substrate 10 forms the second oxide portion 22, and the thickness of the first oxide portion 21 is greater than the thickness of the second oxide portion 22.

Specifically, taking orientation shown in Fig. 3 as an example, in the direction perpendicular to the substrate, the thickness of the first oxide portion 21 gradually decreases from top to bottom, and the thickness of the second oxide portion 22 gradually decreases from top to bottom; in order to ensure accuracy of the thickness of the first oxide portion 21 and the thickness of the second oxide portion 22, in the embodiments, an average thickness of the thickness of the first oxide portion 21 and an average thickness of the second oxide portion 22 are used as the standard for measuring a thickness of the oxide layer, that is, the average thickness of the first oxide portion 21 is greater than the average thickness of the second oxide portion 22.

It should be noted that, in the embodiments, thickness difference between the first oxide portion 21 and the second oxide portion 22 is achieved by controlling process parameters in the atomic layer deposition process, for example, adjusting reaction temperature in the atomic layer deposition process so that the reaction temperature in the atomic layer deposition process is between 600°C and 650°C; and for another example, adjusting ratio of hexachlorodisilane (HCDS), O2 and H2 in the reaction gas, so as to ensure that the thickness of the first oxide portion 21 is greater than the thickness of the second oxide portion 22.

In the embodiments, by making the thickness of the second oxide portion less than the thickness of the first oxide portion, it is equivalent to reducing the thickness of the oxide layer between a bottom-gate structure and the substrate; when a certain voltage is applied to the gate structure, electrons and minority carriers generated by the gate structure can be quickly transferred to the source region or the drain region, so as to improve turn-on current of the semiconductor structure and sensitivity of the semiconductor structure.

In addition, if the thickness of the oxide layer at the junction between the gate structure and the source electrode and the junction between the gate structure and the drain electrode are too small, the risk of the gate induced drain leakage generated by the semiconductor structure will be increased. Therefore, in the embodiments, ratio of the thickness of the second oxide portion 22 to the thickness of the first oxide portion 21 is limited, so that the ratio of the thickness of the second oxide portion 22 to the thickness of the first oxide portion 21 is 75%-95%, and thus on the premise of improving the turn-on current of the semiconductor structure and the sensitivity of the semiconductor structure, the risk of the gate induced drain leakage generated by the semiconductor structure can also be prevented.

In order to ensure stability of the semiconductor structure, in the embodiments of the present application, high temperature treatment is performed on the first oxide portion 21 and the second oxide portion 22, so as to increase compactness of the first oxide portion 21 and compactness of the second oxide portion 22.

Exemplarily, the high temperature treatment is performed on the first oxide portion 21 and the second oxide portion 22 by a thermal annealing process, so as to increase the compactness of the first oxide portion 21 and the compactness of the second oxide portion 22. Compared with the technical solution in the related art that only an atomic layer deposition process is used to form an oxide layer on the side walls and the bottom walls of each of the trench structures 11, the embodiments can increase the compactness of the oxide layer 20 by performing a thermal annealing treatment on the oxide layer, so that the thickness of the oxide layer 20 is between 5nm and 8nm, and it can be ensured that the semiconductor structure is not easily broken down under a certain voltage, thereby improving performance of the semiconductor structure.

In the process of performing the thermal annealing treatment on the first oxide portion 21 and the second oxide portion 22, a reaction temperature in the thermal annealing treatment can be limited, for example, the reaction temperature in the thermal annealing treatment is 600°C-650°C. If the reaction temperature in the thermal annealing treatment is lower than 600°C, it is difficult to ensure the compactness of the first oxide portion and the compactness of the second oxide portion, and if the reaction temperature in the thermal annealing treatment is higher than 650°C, production cost and heat load effect of the semiconductor structure will be increased. Therefore, in the embodiments, the reaction temperature in the thermal annealing treatment process is specifically limited, so as to ensure the compactness of the oxide layer, and reduce the production cost of the semiconductor structure.

Step 400: the oxide layer is nitrided, so that a concentration of nitrogen ions in the first oxide portion is less than a concentration of nitrogen ions in the second oxide portion.

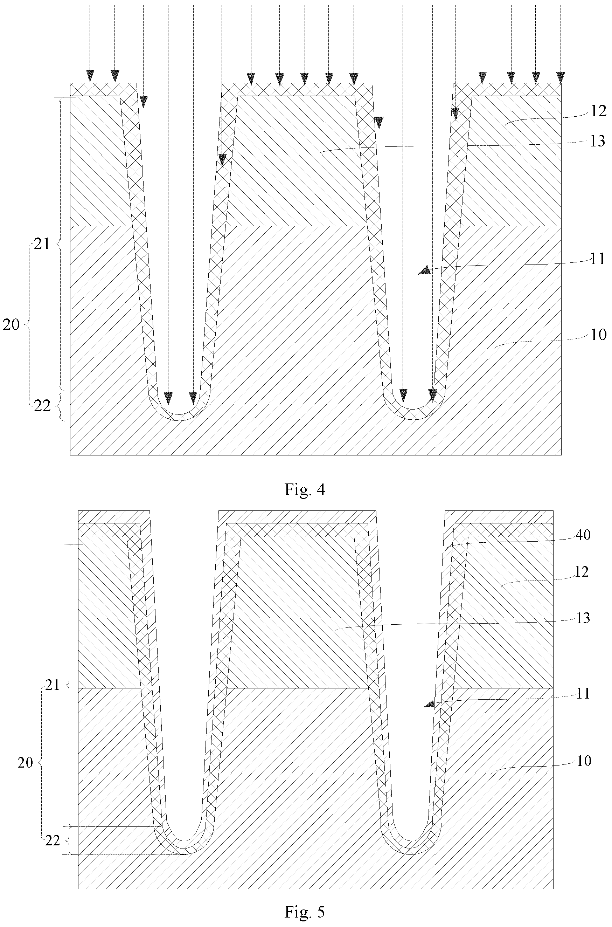

Taking orientation shown in figure 4 as an example, the concentration of the nitrogen ions in the first oxide portion 21 gradually decreases from top to bottom, and the concentration of the nitrogen ions in the second oxide portion 22 gradually decreases from top to bottom. In order to ensure accuracy of the concentration of the nitrogen ions in the first oxide portion 21 and the concentration of the nitrogen ions in the second oxide portion 22, in the embodiments, an average concentration of the nitrogen ions in the first oxide portion 21 and an average concentration of the nitrogen ions in the second oxide portion 22 are used as a measurement standard, that is, the average concentration of the nitrogen ions in the first oxide portion 21 is less than the average concentration of the nitrogen ions in the second oxide portion 22.

In order to reduce the gate induced drain leakage of the semiconductor structure, in the embodiments, the oxide layer 20 is nitrided, for example, as shown in Fig. 4, ammonia gas or nitrogen gas is introduced to the trench structures 11 at 400-850°C, and then the ammonia gas or the nitrogen gas is used to form plasma by plasma treatment technology, so that a surface of the oxide layer 20 can be nitrided to substances similar to silicon oxynitride so as to increase dielectric constant of the oxide layer 20, and the concentration of nitrogen ions in the first oxide portion is less than the concentration of nitrogen ions in the second oxide portion, and then there is a relatively large difference between the dielectric constant of the first oxide portion and the dielectric constant of the second oxide portion, and in this way, the gate induced drain leakage generated at the junction between the gate structure and the source electrode and the junction between the gate structure and the drain electrode can be relatively small, and the turn-on current of the semiconductor structure can also be improved, the sensitivity of the semiconductor structure is improved, and the performance of the semiconductor structure is improved.

It should be noted that, the plasma treatment technology in the embodiments includes a capacitive coupling plasma treatment technology or an inductive coupling plasma treatment technology.

Further, as the gate induced drain leakage is mainly formed at an interface between the gate structure and the drain electrode, the embodiment also limits a ratio of the concentration of nitrogen ions in the first oxide portion 21 to the concentration of nitrogen ions in the second oxide portion 22. By making the concentration of nitrogen ions in the first oxide portion 21 less than the concentration of nitrogen ions in the second oxide portion 22, the gate induced drain leakage is reduced, and the performance of the semiconductor structure is improved.

Specifically, if the ratio of the concentration of nitrogen ions in the first oxide portion 21 to the concentration of nitrogen ions in the second oxide portion 22 is less than 0.1, the concentration of nitrogen ions in the first oxide portion 21 will be reduced, and the dielectric constant of the first oxide portion will be greatly reduced. Although generation of the gate induced drain leakage will be reduced, the turn-on current of the semiconductor structure will also be greatly reduced under the same voltage. If the ratio of the concentration of nitrogen ions in the first oxide portion 21 to the concentration of nitrogen ions in the second oxide portion 22 is greater than 0.5, the generation of the gate induced drain leakage will be increased, and the performance of the semiconductor structure will be affected.

Therefore, in the embodiments, by setting the ratio of the concentration of nitrogen ions in the first oxide portion 21 to the concentration of nitrogen ions in the second oxide portion 22 to between 0.1 and 0.5, the gate induced drain leakage of the semiconductor structure can be reduced, and the turn-on current of the semiconductor structure can also be ensured.

In some embodiments, after the oxide layer is nitrided and before the gate structure is formed in each of the trench structures, the method for manufacturing a semiconductor structure further includes:
As shown in Fig. 5, according to an embodiment not forming part of, but useful to understand the present invention, an initial barrier layer 40 is formed on the oxide layer 20, that is, the initial barrier layer 40 is formed on the oxide layer 20 by an atomic layer deposition process. The initial barrier layer 40 can prevent conductive material of the gate structure from penetrating into the substrate 10, thereby ensuring conductive performance of the gate structure and further improving yield of the semiconductor structure.

Exemplarily, material of the initial barrier layer 40 includes conductive material such as titanium nitride, and the titanium nitride has conductivity while preventing permeation between the conductive material in the gate structure and the substrate, thereby ensuring the performance of the semiconductor structure.

When forming the initial barrier layer, a chemical vapor deposition process is generally used to react titanium chloride with the ammonia gas to form the titanium nitride; however, in the process of forming the titanium nitride, chloride ions tend to remain in the titanium nitride; therefore, it is necessary to nitride the initial barrier layer 40, so as to remove the chloride ions remaining in the initial barrier layer 40.

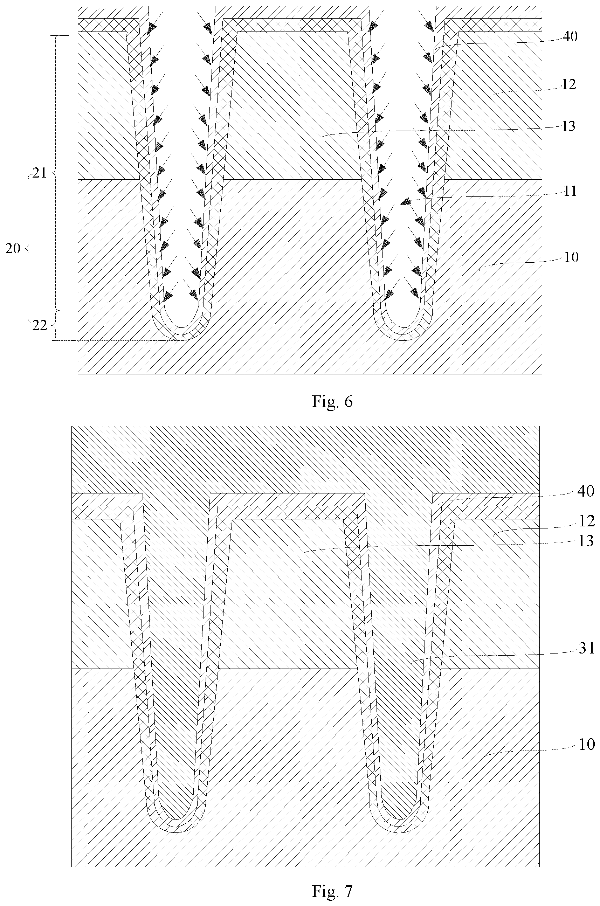

Exemplarily, as shown in Fig. 6, according to an embodiment not forming part of, but useful to understand the present invention, the ammonia gas or the nitrogen gas is supplied to a surface of the initial barrier layer 40 at 400°C-850°C, and then the ammonia gas or the nitrogen gas is formed into plasma by the plasma treatment technology; and the plasma reacts with residual chloride ions, and the residual chloride ions in the titanium nitride are substituted by the nitrogen ions, so as to achieve the purpose of eliminating the residual chloride ions and improving conductivity of the initial barrier layer.

In the embodiments, a concentration of plasma formed on the surface of the initial barrier layer 40 is different. For example, a ratio of a concentration of plasma on the initial barrier layer 40 located on the side walls of each of the trench structures 11 to a concentration of plasma on the initial barrier layer 40 located on the bottom wall of each of the trench structures 11 is greater than 0.8, such that concentration of the residual chloride ions can be removed well, thereby improving the conductivity of the initial conductive layer.

It should be noted that the plasma treatment technology includes capacitive coupling plasma treatment technology or inductive coupling plasma treatment technology.

Step S500: the gate structure is formed in each of the trench structures.

As shown in Fig. 7, specifically, by a physical deposition process or a chemical vapor deposition process, conductive material is deposited into each of the trench structures 11, so as to form the initial conductive layer 31 in each of the trench structures 11, and the initial conductive layer 31 covers the surface of the initial barrier layer 40, and material of the initial conductive layer 31 includes the conductive material such as tungsten.

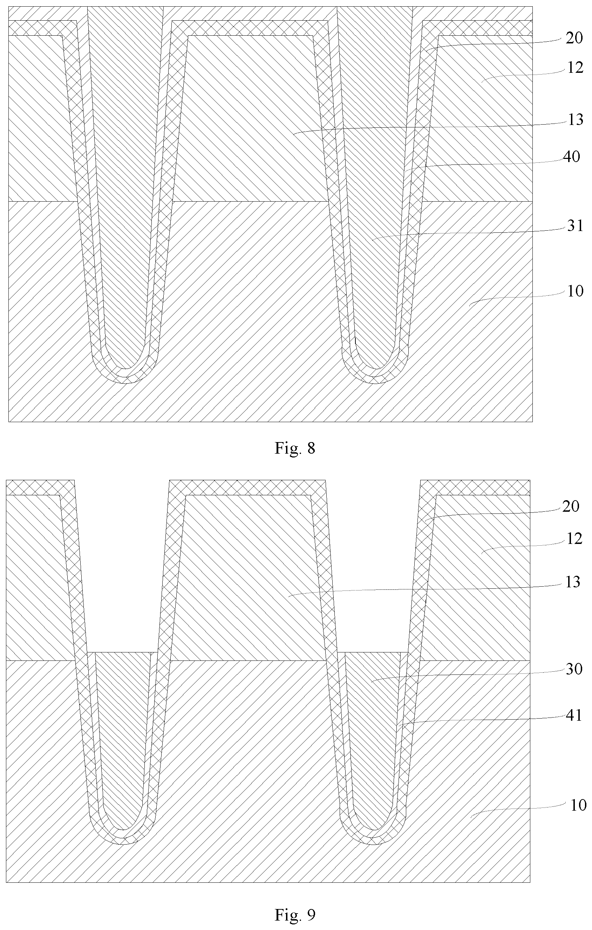

After the initial conductive layer 31 is formed, a chemical mechanical polishing process is used to flatten the initial conductive layer 31, so that a top surface of the initial conductive layer 31 is flush with a top surface of the initial barrier layer 40, and a structure as shown in Fig. 8 is formed.

Then, by a wet etching process, a portion of the initial barrier layer 40 and a portion of the initial conductive layer 31 are removed, that is, the initial barrier layer 40 located on the substrate 10 is removed, and a portion of the initial barrier layer 40 and a portion of the initial conductive layer 31 located in each of the trench structures 11 are removed, a remaining initial barrier layer 40 forms a barrier layer 41, and a remaining initial conductive layer 31 forms the gate structure 30, and a structure thereof is as shown in Fig. 9.

An upper surface of the barrier layer 41 is flush with an upper surface of the gate structure 30, and the upper surface of the gate structure 30 is lower than an upper surface of the substrate 10, so that the trench structures are formed between the gate structure 30 and the upper surface of the substrate 10, so as to subsequently form a gate protection layer in each of the trench structures.

In some embodiments, not forming part of, but useful to understand the present invention, after forming the gate structure in each of the trench structures, the method for manufacturing the semiconductor structure further includes: a gate protection layer is formed, the gate protection layer covering the surface of the substrate and filling each of the trench structures.

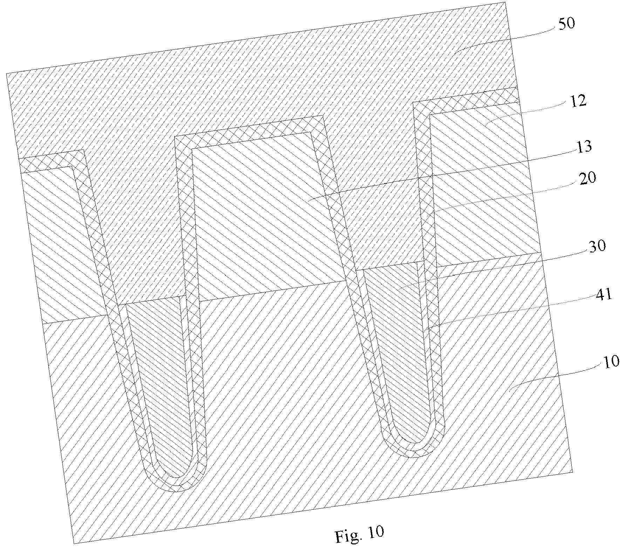

As shown in Fig. 10, insulating material is deposited into each of the trench structures 11 by an atomic layer deposition process or a chemical vapor deposition process, so as to form the gate protection layer 50 on the surface of the gate structure 30, the gate protection layer 50 extending to the surface of the substrate 10 outside each of the trench structures 11, and material of the gate protection layer 50 includes the insulating material such as silicon nitride. In the embodiments, by the arrangement of the gate protection layer 50, insulation arrangement between the gate structure 30 and other conductive structures arranged on the substrate 10 can be realized.

**In** the process of etching the initial barrier layer 40 and the initial conductive layer 31 and transferring the semiconductor structure from an etching machine to a deposition machine, metal tungsten on the surface of the gate structure 30 is oxidized into tungsten oxide. Therefore, in the embodiments, after forming the gate structure in each of the trench structures and before forming the gate protection layer, hydrogen gas or ammonia gas is introduced to the surface of the gate structure 30, and the gate structure 30 is plasma-treated at 600°C-760°C, so as to improve the conductivity of the gate structure 30.

Exemplarily, at 600°C-760°C, the ammonia gas or the hydrogen gas is introduced to the surface of the gate structure 30, and then the ammonia gas or the hydrogen gas is formed into plasma by plasma treatment technology. The plasma reacts with the tungsten oxide, and reduces the tungsten oxide on the surface of the gate structure 30 to tungsten, so as to improve the conductivity of the gate structure and reduce resistance of the gate structure, thereby improving the turning-on current of the gate structure.

The embodiments of the present application further provide a semiconductor structure. As shown in figure 10, the semiconductor structure includes a substrate 10, an oxide layer 20 and a gate structure 30, and trench structures 11 are provided in the substrate 10, the number of the trench structures 11 is multiple, and the trench structures 11 are provided at intervals in the substrate 10.

The oxide layer 20 is provided in the trench structures 10, and the oxide layer 20 includes a first oxide portion 21 and a second oxide portion 22, and the first oxide portion 21 covers side walls of each of the trench structures 11, and the second oxide portion 22 covers a bottom wall of each of the trench structures 11.

A thickness of the second oxide portion 22 is less than a thickness of the first oxide portion 21, which is used for increasing turn-on current of the semiconductor structure and improving sensitivity of the semiconductor structure.

A concentration of nitrogen ions in the first oxide portion 21 is less than a concentration of nitrogen ions in the second oxide portion 22, to better reduce gate induced drain leakage, thereby improving performance of the semiconductor structure.

The gate structure 30 is provided in each of the trench structures 11, and a top surface of the gate structure 30 is lower than a top surface of the substrate 10.

In order to prevent conductive material in the gate structure 30 from diffusing into the substrate 10, a barrier layer 41 is further provided between the oxide layer 20 and the gate structure 30. By the arrangement of the barrier layer 41, permeation between the conductive material in the gate structure and the substrate is prevented, and the barrier layer 41 also has conductivity, ensuring the performance of the semiconductor structure.

In the embodiments, not forming part of, but useful to understand the present invention, material of the barrier layer 41 includes conductive material such as titanium nitride, and material of the gate structure 30 includes conductive material such as metal tungsten.

In the semiconductor structure provided by the embodiments, by making the thickness of the second oxide portion be less than the thickness of the first oxide portion, and in combination with the fact that the concentration of nitrogen ions in the first oxide portion is less than that of the second oxide portion, dielectric constant of the first oxide portion is less than dielectric constant of the second oxide portion. Such an arrangement can ensure that the semiconductor structure generates small gate induced drain leakage at a junction between the gate structure and a source electrode and a junction between the gate structure and a drain electrode, and can also improve the turn-on current of the semiconductor structure, thereby improving the sensitivity of the semiconductor structure.

Further, the embodiments also limits the concentration of nitrogen ions in the first oxide portion and the concentration of nitrogen ions in the second oxide portion; if the ratio of the concentration of nitrogen ions in the first oxide portion 21 to the concentration of nitrogen ions in the second oxide portion 22 is less than 0.1, the concentration of nitrogen ions in the first oxide portion 21 will be reduced, and the dielectric constant of the first oxide portion will be greatly reduced; although the generation of the gate induced drain leakage will be reduced, the turn-on current of the semiconductor structure will also be greatly reduced under the same voltage; and if the ratio of the concentration of nitrogen ions in the first oxide portion 21 to the concentration of nitrogen ions in the second oxide portion 22 is greater than 0.5, the generation of the gate induced drain leakage will be increased, and the performance of the semiconductor structure will be affected.

Therefore, in the embodiments, by setting the ratio of the concentration of nitrogen ions in the first oxide portion to the concentration of nitrogen ions in the second oxide portion to between 0.1 and 0.5, the gate induced drain leakage can be reduced, and the turn-on current of the semiconductor structure can also be ensured.

In some embodiments, not forming part of, but useful to understand the present invention, the semiconductor structure provided by the embodiments further includes a gate protection layer 50. The gate protection layer 50 is provided on a surface of the barrier layer 41 and the gate structure 30, and fills each of the trench structures 11. In the embodiments, by providing the gate protection layer 50, insulation between the gate structure 30 and other conductive structures provided on the substrate 10 can be achieved.

The embodiments or implementations in this description are described in a progressive manner, each of the embodiments emphasizes the differences from one another, and same and similar parts of the various embodiments can make reference to one another.

Reference throughout this description to "an embodiment", "some embodiments", "an exemplary embodiment, "an example", "a specific example", "or some examples" means that a particular feature, structure, material, or characteristic described in connection with the embodiment or example is included in at least one embodiment or example of the present application.

Thus, expressions of the terms above are not necessarily referring to the same embodiment or example of the present disclosure. Furthermore, the particular features, structures, materials, or characteristics may be combined in any suitable manner in one or more embodiments or examples.

Finally, it should be noted that the foregoing embodiments are merely intended to describe the technical solutions of the present application, but not intended to limit the present application.

## Claims

1. A method for manufacturing a semiconductor structure, comprising:
providing a substrate (10), the substrate(10) comprising trench structures(11) distributed at intervals;
forming a source region (12) and a drain region(13) respectively on both sides of each of the trench structures(11);
forming an oxide layer(20), the oxide layer(20) comprising a first oxide portion(21) and a second oxide portion(22), wherein the first oxide portion(21) covers side walls of each of the trench structures(11), the second oxide portion(22) covers a bottom wall of each of the trench structures(11), and a thickness of the second oxide portion(22) is less than a thickness of the first oxide portion(21);
nitriding the oxide layer (20), so that a concentration of nitrogen ions in the first oxide portion(21) is less than a concentration of nitrogen ions in the second oxide portion(22);
forming a gate structure (30) in each of the trench structures(11);
wherein a ratio of the concentration of the nitrogen ions in the first oxide portion (21) to the concentration of the nitrogen ions in the second oxide portion(22) is between 0.1 and 0.5.

2. The method for manufacturing the semiconductor structure according to claim 1, wherein nitriding the oxide layer (20) comprises:
at 400°C-850°C, introducing ammonia gas or nitrogen gas to a surface of the oxide layer (20), and then nitriding the oxide layer(20) by plasma treatment.

3. The method for manufacturing the semiconductor structure according to claim 1, wherein forming the oxide layer (20) comprises:
forming a silicon oxide layer on the side walls and the bottom wall of each of the trench structures (11) by an atomic layer deposition process, wherein the silicon oxide layer covering the side walls of each of the trench structures(11) forms the first oxide portion(21), and the silicon oxide covering the bottom wall of each of the trench structures(11) forms the second oxide portion(22);
performing high temperature treatment on the first oxide portion (21) and the second oxide portion(22), so as to increase compactness of the first oxide portion(21) and compactness of the second oxide portion(22).

4. The method for manufacturing the semiconductor structure according to claim 3, wherein performing the high temperature treatment on the first oxide portion (21) and the second oxide portion(22) comprises: performing a thermal annealing treatment process on the first oxide portion(21) and the second oxide portion(22), wherein a reaction temperature in the thermal annealing treatment process is 600°C-650°C.

5. The method for manufacturing the semiconductor structure according to claim 4, wherein a ratio of the thickness of the second oxide portion (22) to the thickness of the first oxide portion(21) is 75%-95%.

6. A semiconductor structure, comprising:
a substrate (10), the substrate(10) having trench structures(11);
a source region (12) and a drain region(13) respectively on both sides of each of the trench structures(11);
an oxide layer(20), the oxide layer(20) comprising a first oxide portion(21) and a second oxide portion(22), the first oxide portion(21) covers side walls of each of the trench structures(11), the second oxide portion(22) covers a bottom wall of each of the trench structures(11), a thickness of the second oxide portion(22) is less than a thickness of the first oxide portion(21), and a concentration of nitrogen ions in the first oxide portion(21) is less than a concentration of nitrogen ions in the second oxide portion(22);
a gate structure(30), the gate structure(30) being provided in each of the trench structures(11), and a top surface of the gate structure(30) being lower than a top surface of the substrate(10);
wherein a ratio of the concentration of nitrogen ions in the first oxide portion(21) to the concentration of nitrogen ions in the second oxide portion(22) is between 0.1 and 0.5.

7. The semiconductor structure according to claim 6, wherein the semiconductor structure further comprises a barrier layer(41), the barrier layer(41) is located between the oxide layer(20) and the gate structure(30).

8. The semiconductor structure according to claim 7, wherein the semiconductor structure further comprises a gate protection layer(50), the gate protection layer(50) is provided on a surface of the barrier layer(41) and a surface of the gate structure(30), and fills the trench structure.

## Patentansprüche

1. Verfahren zur Herstellung einer Halbleiterstruktur, umfassend:
Bereitstellen eines Substrats (10), welches Substrat (10) in Abständen verteilte Grabenstrukturen (11) aufweist;
Bilden einer Source-Zone (12) und einer Drain-Zone (13) jeweils auf beiden Seiten jeder der Grabenstrukturen (11);
Bilden einer Oxidschicht (20), welche Oxidschicht (20) einen ersten Oxidanteil (21) und einen zweiten Oxidanteil (22) umfasst, wobei der erste Oxidanteil (21) Seitenwände jeder der Grabenstrukturen (11) überdeckt, während der zweite Oxidanteil (22) eine Bodenwand jeder der Grabenstrukturen (11) überdeckt, und wobei eine Dicke des zweiten Oxidanteils (22) geringer als eine Dicke des ersten Oxidanteils (21) ist;
Nitrieren der Oxidschicht (20), so dass eine Konzentration von Stickstoffionen in dem ersten Oxidanteil (21) geringer als eine Konzentration von Stickstoffionen in dem zweiten Oxidanteil (22) ist;
Bilden einer Gate-Struktur (30) in jeder der Grabenstrukturen (11);
wobei ein Verhältnis der Konzentration der Stickstoffionen in dem ersten Oxidanteil (21) zu der Konzentration der Stickstoffionen in dem zweiten Oxidanteil (22) zwischen 0,1 und 0,5 liegt.

2. Verfahren zur Herstellung der Halbleiterstruktur nach Anspruch 1, wobei das Nitrieren der Oxidschicht (20) Folgendes umfasst:
Einführen von Ammoniakgas oder Stickstoffgas bei 400 °C bis 850 °C auf eine Oberfläche der Oxidschicht (20) und anschließendes Nitrieren der Oxidschicht (20) durch Plasmabehandlung.

3. Verfahren zur Herstellung der Halbleiterstruktur nach Anspruch 1, wobei das Bilden der Oxidschicht (20) Folgendes umfasst:
Bilden einer Siliziumoxidschicht auf den Seitenwänden und der Bodenwand jeder der Grabenstrukturen (11) durch einen Atomlagenabscheidungsprozess, wobei die Siliziumoxidschicht, die die Seitenwände jeder der Grabenstrukturen (11) überdeckt, den ersten Oxidanteil (21) bildet, während das Siliziumoxid, das die Bodenwand jeder der Grabenstrukturen (11) überdeckt, den zweiten Oxidanteil (22) bildet;
Durchführen einer Hochtemperaturbehandlung an dem ersten Oxidanteil (21) und dem zweiten Oxidanteil (22), um die Kompaktheit des ersten Oxidanteils (21) und des zweiten Oxidanteils (22) zu erhöhen.

4. Verfahren zur Herstellung der Halbleiterstruktur nach Anspruch 3, wobei das Durchführen der Hochtemperaturbehandlung an dem ersten Oxidanteil (21) und dem zweiten Oxidanteil (22) Folgendes umfasst: Durchführen eines thermischen Glühbehandlungsprozesses an dem ersten Oxidanteil (21) und dem zweiten Oxidanteil (22), wobei eine Reaktionstemperatur in dem thermischen Glühbehandlungsprozess 600 °C bis 650 °C beträgt.

5. Verfahren zur Herstellung der Halbleiterstruktur nach Anspruch 4, wobei ein Verhältnis der Dicke des zweiten Oxidanteils (22) zur Dicke des ersten Oxidanteils (21) 75 % bis 95 % beträgt.

6. Halbleiterstruktur, umfassend:
ein Substrat (10), welches Substrat (10) Grabenstrukturen (11) aufweist;
eine Source-Zone (12) und eine Drain-Zone (13) jeweils auf beiden Seiten jeder der Grabenstrukturen (11);
eine Oxidschicht (20), welche Oxidschicht (20) einen ersten Oxidanteil (21) und einen zweiten Oxidanteil (22) umfasst, wobei der erste Oxidanteil (21) Seitenwände jeder der Grabenstrukturen (11) überdeckt, während der zweite Oxidanteil (22) eine Bodenwand jeder der Grabenstrukturen (11) überdeckt, wobei eine Dicke des zweiten Oxidanteils (22) geringer als eine Dicke des ersten Oxidanteils (21) ist, und wobei eine Konzentration von Stickstoffionen in dem ersten Oxidanteil (21) geringer als eine Konzentration von Stickstoffionen in dem zweiten Oxidanteil (22) ist;
eine Gate-Struktur (30), welche Gate-Struktur (30) in jeder der Grabenstrukturen (11) vorgesehen ist, wobei eine Oberseite der Gate-Struktur (30) niedriger als eine Oberseite des Substrats (10) ist;
wobei ein Verhältnis der Konzentration von Stickstoffionen in dem ersten Oxidanteil (21) zu der Konzentration von Stickstoffionen in dem zweiten Oxidanteil (22) zwischen 0,1 und 0,5 liegt.

7. Halbleiterstruktur nach Anspruch 6, wobei die Halbleiterstruktur ferner eine Barriereschicht (41) umfasst, welche Barriereschicht (41) zwischen der Oxidschicht (20) und der Gate-Struktur (30) angeordnet ist.

8. Halbleiterstruktur nach Anspruch 7, wobei die Halbleiterstruktur ferner eine Gate-Schutzschicht (50) umfasst, welche Gate-Schutzschicht (50) auf einer Oberfläche der Barriereschicht (41) und einer Oberfläche der Gate-Struktur (30) vorgesehen ist und die Grabenstruktur füllt.

## Revendications

1. Procédé de fabrication d'une structure semi-conductrice, comprenant :
fournir un substrat (10), le substrat (10) comprenant des structures de tranchée (11) réparties à intervalles ;
former respectivement une région de source (12) et une région de drain (13) sur deux côtés de chacune des structures de tranchée (11) ;
former une couche d'oxyde (20), la couche d'oxyde (20) comprenant une première portion d'oxyde (21) et une seconde portion d'oxyde (22), dans lequel la première portion d'oxyde (21) recouvre des parois latérales de chacune des structures de tranchée (11), la seconde portion d'oxyde (22) recouvre une paroi inférieure de chacune des structures de tranchée (11), et une épaisseur de la seconde portion d'oxyde (22) est inférieure à une épaisseur de la première portion d'oxyde (21) ;
nitrurer la couche d'oxyde (20), de sorte qu'une concentration d'ions d'azote dans la première portion d'oxyde (21) soit inférieure à une concentration d'ions d'azote dans la seconde portion d'oxyde (22) ;
former une structure de grille (30) dans chacune des structures de tranchée (11) ;
dans lequel un rapport de la concentration des ions d'azote dans la première portion d'oxyde (21) à la concentration des ions d'azote dans la seconde portion d'oxyde (22) est compris entre 0,1 et 0,5.

2. Procédé de fabrication de la structure semi-conductrice selon la revendication 1, dans lequel la nitruration de la couche d'oxyde (20) comprend :
à 400°C-850°C, introduire un gaz d'ammoniac ou un gaz d'azote à une surface de la couche d'oxyde (20), puis nitrurer la couche d'oxyde (20) par traitement au plasma.

3. Procédé de fabrication de la structure semi-conductrice selon la revendication 1, dans lequel la formation de la couche d'oxyde (20) comprend :
former une couche d'oxyde de silicium sur les parois latérales et la paroi inférieure de chacune des structures de tranchée (11) par un processus de dépôt de couche atomique, dans lequel la couche d'oxyde de silicium recouvrant les parois latérales de chacune des structures de tranchée (11) forme la première portion d'oxyde (21), et l'oxyde de silicium recouvrant la paroi inférieure de chacune des structures de tranchée (11) forme la seconde portion d'oxyde (22) ;
exécuter un traitement à haute température sur la première portion d'oxyde (21) et la seconde portion d'oxyde (22), afin d'augmenter la compacité de la première portion d'oxyde (21) et la compacité de la seconde portion d'oxyde (22).

4. Procédé de fabrication de la structure semi-conductrice selon la revendication 3, dans lequel l'exécution du traitement à haute température sur la première portion d'oxyde (21) et la seconde portion d'oxyde (22) comprend : exécuter un processus de traitement par recuit thermique sur la première portion d'oxyde (21) et la seconde portion d'oxyde (22), dans lequel une température de réaction dans le processus de traitement par recuit thermique est de 600°C à 650°C.

5. Procédé de fabrication de la structure semi-conductrice selon la revendication 4, dans lequel un rapport de l'épaisseur de la seconde portion d'oxyde (22) à l'épaisseur de la première portion d'oxyde (21) est de 75 % à 95 %.

6. Structure semi-conductrice, comprenant :
un substrat (10), le substrat (10) comprenant des structures de tranchée (11) ;
une région de source (12) et une région de drain (13) sur deux côtés de chacune des structures de tranchée (11) respectivement ;
une couche d'oxyde (20), la couche d'oxyde (20) comprenant une première portion d'oxyde (21) et une seconde portion d'oxyde (22), la première portion d'oxyde (21) recouvrant des parois latérales de chacune des structures de tranchée (11), la seconde portion d'oxyde (22) recouvrant une paroi inférieure de chacune des structures de tranchée (11), une épaisseur de la seconde portion d'oxyde (22) étant inférieure à une épaisseur de la première portion d'oxyde (21), et une concentration d'ions d'azote dans la première portion d'oxyde (21) étant inférieure à une concentration d'ions d'azote dans la seconde portion d'oxyde (22) ;
une structure de grille (30), la structure de grille (30) étant prévue dans chacune des structures de tranchée (11), et une surface supérieure de la structure de grille (30) étant inférieure à une surface supérieure du substrat (10) ;
dans laquelle un rapport de la concentration d'ions d'azote dans la première portion d'oxyde (21) à la concentration d'ions d'azote dans la seconde portion d'oxyde (22) est compris entre 0,1 et 0,5.

7. Structure semi-conductrice selon la revendication 6, dans laquelle la structure semi-conductrice comprend en outre une couche barrière (41), la couche barrière (41) étant située entre la couche d'oxyde (20) et la structure de grille (30).

8. Structure semi-conductrice selon la revendication 7, dans laquelle la structure semi-conductrice comprend en outre une couche protectrice de grille (50), la couche protectrice de grille (50) étant prévue sur une surface de la couche barrière (41) et une surface de la structure de grille (30), et remplissant la structure de tranchée.
